# EUROPEAN PATENT SPECIFICATION

(11) **EP 3 554 748 B1**
(45) Date of publication and mention of the grant of the patent: **15.06.2022**
(21) Application number: 17794578.9
(22) Date of filing: 24.10.2017
(51) Int. Cl.: B22D 29/00, B22C 9/02, B22C 13/08, B22C 9/10, B22C 9/24, B22D 27/04, B28B 1/00, F01D 5/16, G03F 7/00, B29C 64/124

(54) **INTEGRATED CASTING CORE-SHELL STRUCTURE WITH FLOATING TIP PLENUM**
INTEGRIERTE KERN-SCHALE-GIESSSTRUKTUR MIT SCHWIMMENDER SPITZENKAMMER
STRUCTURE NOYAU-ENVELOPPE DE COULÉE INTÉGRÉE AVEC CHAMBRE DE POINTE FLOTTANTE

(30) Priority: 13.12.2016 US 201615377711
(43) Date of publication of application: 23.10.2019
(73) Proprietor: General Electric Company, Schenectady, NY 12345 (US)
(72) Inventor: DEINES, James, Herbert, Cincinnati, OH 45215 (US); PRZESLAWSKI, Brian, David, Liberty Township, OH 45044 (US); MCCARREN, Michael, John, Cincinnati, OH 45215 (US); GARAY, Gregory, Terrence, West Chester, OH 45069 (US); KONITZER, Douglas, Gerard, Cincinnati, OH 45215 (US); MARUSKO, Mark, Willard, Cincinnati, OH 45215-1988 (US); YANG, Xi, West Chester, OH 45209 (US); PETERSON, Brian, Patrick, Dayton, OH 45434 (US)
(74) Representative: Hafner & Kohl PartmbB
(86) International application number: PCT/US2017/057945
(87) International publication number: WO 2018/111408

(56) References cited:
- WO-A1-00/51761
- US-A- 6 117 612
- US-A1- 2008 080 979
- US-A1- 2016 221 262
- US-B2- 9 079 357
- Chang-Jun Bae: "Integrally Cored Ceramic Investment Casting Mold Fabricated by Ceramic Stereolithography", , 1 January 2008 (2008-01-01), XP055437811, Retrieved from the Internet: URL:https://deepblue.lib.umich.edu/bitstre am/handle/2027.42/61652/baecj_1.pdf?sequen ce=1 [retrieved on 2018-01-02]

## Description

The present disclosure generally relates to investment casting core-shell mold components and processes utilizing these components. The core-shell mold made in accordance with the present invention includes integrated ceramic filaments between the core and shell of the mold that can be utilized to form holes, i.e., effusion cooling holes, in the cast component made from these molds. The use of sufficient ceramic filaments between core and shell to both locate and provide leaching pathways for the core serpentine also enables the elimination of ball braze chutes. Ceramic filaments between the tip plenum core and the shell may also be provided to support a floating tip plenum, eliminating the need for traditional tip pins, and their subsequent closure by brazing. The integrated core-shell molds provide useful properties in casting operations, such as in the casting of superalloys used to make turbine blades and stator vanes for jet aircraft engines or power generation turbine components.

### BACKGROUND

Many modern engines and next generation turbine engines require components and parts having intricate and complex geometries, which require new types of materials and manufacturing techniques. Conventional techniques for manufacturing engine parts and components involve the laborious process of investment or lost-wax casting. One example of investment casting involves the manufacture of a typical rotor blade used in a gas turbine engine. A turbine blade typically includes hollow airfoils that have radial channels extending along the span of a blade having at least one or more inlets for receiving pressurized cooling air during operation in the engine. The various cooling passages in a blade typically include a serpentine channel disposed in the middle of the airfoil between the leading and trailing edges. The airfoil typically includes inlets extending through the blade for receiving pressurized cooling air, which include local features such as short turbulator ribs or pins for increasing the heat transfer between the heated sidewalls of the airfoil and the internal cooling air.

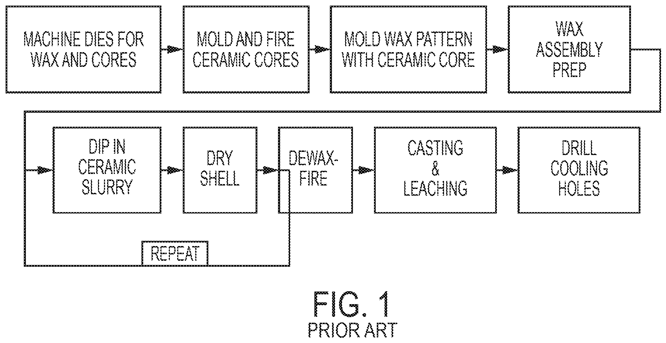

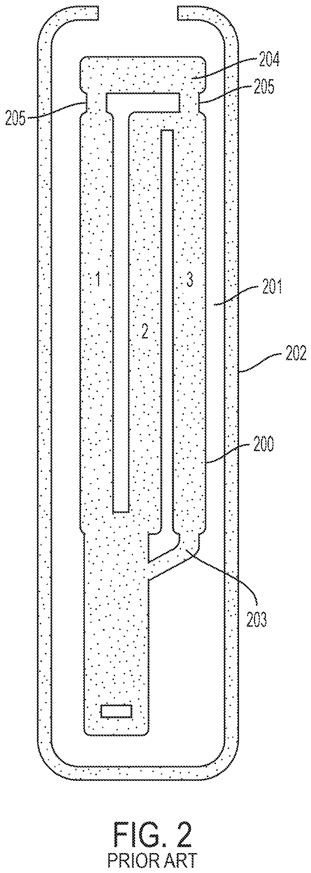

The manufacture of these turbine blades, typically from high strength, superalloy metal materials, involves numerous steps shown in FIG. 1. First, a precision ceramic core is manufactured to conform to the intricate cooling passages desired inside the turbine blade. A precision die or mold is also created which defines the precise 3-D external surface of the turbine blade including its airfoil, platform, and integral dovetail. A schematic view of such a mold structure is shown in FIG. 2. The ceramic core 200 is assembled inside two die halves which form a space or void therebetween that defines the resulting metal portions of the blade. Wax is injected into the assembled dies to fill the void and surround the ceramic core encapsulated therein. The two die halves are split apart and removed from the molded wax. The molded wax has the precise configuration of the desired blade and is then coated with a ceramic material to form a surrounding ceramic shell 202. Then, the wax is melted and removed from the shell 202 leaving a corresponding void or space 201 between the ceramic shell 202 and the internal ceramic core 200 and tip plenum 204. Molten superalloy metal is then poured into the shell to fill the void therein and again encapsulate the ceramic core 200 and tip plenum 204 contained in the shell 202. The molten metal is cooled and solidifies, and then the external shell 202 and internal core 200 and tip plenum 204 are suitably removed leaving behind the desired metallic turbine blade in which the internal cooling passages are found. In order to provide a pathway for removing ceramic core material via a leaching process, a ball chute 203 and tip pins 205 are provided, which upon leaching form a ball chute and tip holes within the turbine blade that must subsequently brazed shut.

The cast turbine blade may then undergo additional post-casting modifications, such as but not limited to drilling of suitable rows of film cooling holes through the sidewalls of the airfoil as desired for providing outlets for the internally channeled cooling air which then forms a protective cooling air film or blanket over the external surface of the airfoil during operation in the gas turbine engine. After the turbine blade is removed from the ceramic mold, the ball chute 203 of the ceramic core 200 forms a passageway that is later brazed shut to provide the desired pathway of air through the internal voids of the cast turbine blade. However, these post-casting modifications are limited and given the ever increasing complexity of turbine engines and the recognized efficiencies of certain cooling circuits inside turbine blades, more complicated and intricate internal geometries are required. While investment casting is capable of manufacturing these parts, positional precision and intricate internal geometries become more complex to manufacture using these conventional manufacturing processes. Accordingly, it is desired to provide an improved casting method for three dimensional components having intricate internal voids.

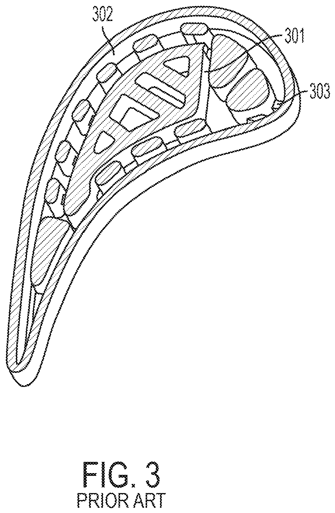

Methods for using 3-D printing to produce a ceramic core-shell mold are described in U.S. Patent No. 8,851,151 assigned to Rolls-Royce Corporation. The methods for making the molds include powder bed ceramic processes such as disclosed U.S. Patent No. 5,387,380 assigned to Massachusetts Institute of Technology, and selective laser activation (SLA) such as disclosed in U.S. Patent No. 5,256,340 assigned to 3D Systems, Inc. The ceramic core-shell molds according to the '151 patent are limited by the printing resolution capabilities of these processes. As shown in Fig. 3, the core portion 301 and shell portion 302 of the integrated core-shell mold is held together via a series of tie structures 303 provided at the bottom edge of the mold. Cooling passages are proposed in the '151 patent that include staggered vertical cavities joined by short cylinders, the length of which is nearly the same as its diameter. A superalloy turbine blade is then formed in the core-shell mold using known techniques disclosed in the '151 patent, and incorporated herein by reference. After a turbine blade is cast in one of these core-shell molds, the mold is removed to reveal a cast superalloy turbine blade.

Chang-Jun Bae, "Integrally Cored Ceramic Investment Casting Mold Fabricated by Ceramic Stereolithography" as well as Chang-Jun Bae, "Integrally Cored Ceramic Investment Casting Mold Fabricated by Ceramic Stereolithography" disclose principles using stereolithography for manufacturing investment casting molds.

US 2016221262, WO 0051761, US 6117612, US 2008080979, and US 9079357 discloses further principles for manufacturing investment casting molds.

There remains a need to prepare ceramic core-shell molds produced using higher resolution methods that are capable of providing fine detail cast features in the end-product of the casting process.

### SUMMARY

In one embodiment, the invention relates to a method for fabricating a ceramic mold in accordance with Claim 1. The method includes steps (a)-(d). Step (a) involves contacting a cured portion of a workpiece with a liquid ceramic photopolymer. Step (b) involves irradiating a portion of the liquid ceramic photopolymer adjacent to the cured portion through a window contacting the liquid ceramic photopolymer. Step (c) involves removing the workpiece from the uncured liquid ceramic photopolymer; and (d) repeating steps (a) - (c) until a ceramic mold is formed. The ceramic mold formed in the process includes a main core portion, a core tip portion, and a shell portion with at least one cavity between the core portion and the shell portion. The cavity defines the shape of a cast component upon casting and removal of the ceramic mold. At least one ceramic tip filament connects the core tip portion and the shell portion. The tip filaments support the core tip portion during casting and eliminate the need for tip pins or a shell lock to hold the tip plenum in place during casting. When the tip filaments form a cooling hole pattern in the tip plenum, the filaments have a cross sectional area on the order of those used to make cooling holes, 0.01 to 2 mm². The large number of filaments used to form a cooling hole pattern may provide sufficient strength to support the tip core. If the tip filaments are made to support tip plenum core, they may be made larger, i.e., >2 mm cross section area, and a much lower number of filaments, or a single filament, could be used. Although two to four of these larger filaments is a desirable number. After casting, any holes or notches remaining in the tip plenum sidewalls as a result of the filaments may be brazed shut or incorporated into the turbine blade or stator vane design.

In another aspect, the invention relates to a method of preparing a cast component in accordance with Claim 8. The method includes pouring a liquid metal into a ceramic casting mold and solidifying the liquid metal to form the cast component. The ceramic mold formed in the process includes a main core portion, a core tip portion, and a shell portion with at least one cavity between the core portion and the shell portion. The cavity defines the shape of a cast component upon casting and removal of the ceramic mold. At least one ceramic tip filament connects the core tip portion and the shell portion.

In another aspect, the invention involves a ceramic casting mold in accordance with Claim 11. The ceramic casting mold includes a main core portion, a core tip portion, and a shell portion with at least one cavity between the core portion and the shell portion. The cavity defines the shape of a cast component upon casting and removal of the ceramic mold. At least one ceramic tip filament connects the core tip portion and the shell portion. Preferably, the cast component is a turbine blade or a stator vane and the ceramic mold comprises a plurality of cooling hole filaments joining the main core portion and the shell portion where each filament spans between the main core and the shell. Preferably the turbine blade is used in a gas turbine engine in, for example, an aircraft engine or power generation. The turbine blade or stator vane is preferably a single crystal cast turbine blade or stator vane having a cooling hole pattern defined by the ceramic filaments mentioned above. The cooling hole filaments are adapted to define a plurality of cooling holes in the turbine blade or stator vane upon removal of the mold. The cooling hole filaments have a cross sectional area ranging from 0.01 to 2 mm².

### BRIEF DESCRIPTION OF THE DRAWINGS

FIG. 1 is a flow diagram showing the steps for conventional investment casting.
FIG. 2 is a schematic diagram showing an example of a conventional scheme for a core-shell mold with ball chute prepared by a conventional process.
FIG. 3 shows a perspective view of a prior art integrated core-shell mold with ties connecting the core and shell portions.
FIGS. 4, 5, 6 and 7 show schematic lateral sectional views of a device for carrying out successive phases of the method sequence for direct light processing (DLP).
FIG. 8 shows a schematic sectional view along the line A-A of FIG. 7.
FIG. 9 shows a side view of an integrated core-shell mold with filaments connecting the core and shell portions.
FIG. 10 shows a side view of an integrated core-shell mold not according to an embodiment of the present invention.
FIG. 11 shows a side view of a superalloy-filled integrated core-shell mold not according to an embodiment of the present invention.
FIG. 12 is a schematic view of an integrated core shell mold having core print filaments exiting above a blade tip in accordance with an embodiment of the invention.
FIG. 13 is a schematic view of an integrated core shell mold having core print filaments exiting beside a blade tip in accordance with an embodiment of the invention.

### DETAILED DESCRIPTION

The detailed description set forth below in connection with the appended drawings is intended as a description of various configurations and is not intended to represent the only configurations in which the concepts described herein may be practiced. The detailed description includes specific details for the purpose of providing a thorough understanding of various concepts. However, it will be apparent to those skilled in the art that these concepts may be practiced without these specific details. For example, the present invention provides a preferred method for making cast metal parts, and preferably those cast metal parts used in the manufacture of jet aircraft engines. Specifically, the production of single crystal, nickel-based superalloy cast parts such as turbine blades, vanes, and shroud components can be advantageously produced in accordance with this invention. However, other cast metal components may be prepared using the techniques and integrated ceramic molds of the present invention.

The present inventors recognized that prior processes known for making integrated core-shell molds lacked the fine resolution capability necessary to print filaments extending between the core and shell portion of the mold of sufficiently small size and quantity to result in effusion cooling holes in the finished turbine blade. In the case of earlier powder bed processes, such as disclosed in U.S. Patent No. 5,387,380 assigned to Massachusetts Institute of Technology, the action of the powder bed recoater arm precludes formation of sufficiently fine filaments extending between the core and shell to provide an effusion cooling hole pattern in the cast part. Other known techniques such as selective laser activation (SLA) such as disclosed in U.S. Patent No. 5,256,340 assigned to 3D Systems, Inc. that employ a top-down irradiation technique may be utilized in producing an integrated core-shell mold in accordance with the present invention. However, the available printing resolution of these systems significantly limit the ability to make filaments of sufficiently small size to serve as effective cooling holes in the cast final product.

The present inventors have found that the integrated core-shell mold of the present invention can be manufactured using direct light processing (DLP). DLP differs from the above discussed powder bed and SLA processes in that the light curing of the polymer occurs through a window at the bottom of a resin tank that projects light upon a build platform that is raised as the process is conducted. With DLP an entire layer of cured polymer is produced simultaneously, and the need to scan a pattern using a laser is eliminated. Further, the polymerization occurs between the underlying window and the last cured layer of the object being built. The underlying window provides support allowing thin filaments of material to be produced without the need for a separate support structure. In other words, producing a thin filament of material bridging two portions of the build object is difficult and was typically avoided in the prior art. For example, the ' 151 patent discussed above in the background section of this application used vertical plate structures connected with short cylinders, the length of which was on the order of their diameter. Staggered vertical cavities are necessitated by the fact that the powder bed and SLA techniques disclosed in the ' 151 patent require vertically supported ceramic structures and the techniques are incapable of reliably producing filaments. In addition, the available resolution within a powder bed is on the order of 1/8" making the production of traditional cooling holes impracticable. For example, round cooling holes generally have a diameter of less than 2 mm corresponding to a cooling hole area below 3.2 mm². Production of a hole of such dimensions requires a resolution far below the size of the actual hole given the need to produce the hole from several voxels. This resolution is simply not available in a powder bed process. Similarly, stereolithography is limited in its ability to produce such filaments due to lack of support and resolution problems associated with laser scattering. But the fact that DLP exposes the entire length of the filament and supports it between the window and the build plate enables producing sufficiently thin filaments spanning the entire length between the core and shell to form a ceramic object having the desired cooling hole pattern. Although powder bed and SLA may be used to produce filaments, their ability to produce sufficiently fine filaments as discussed above is limited.

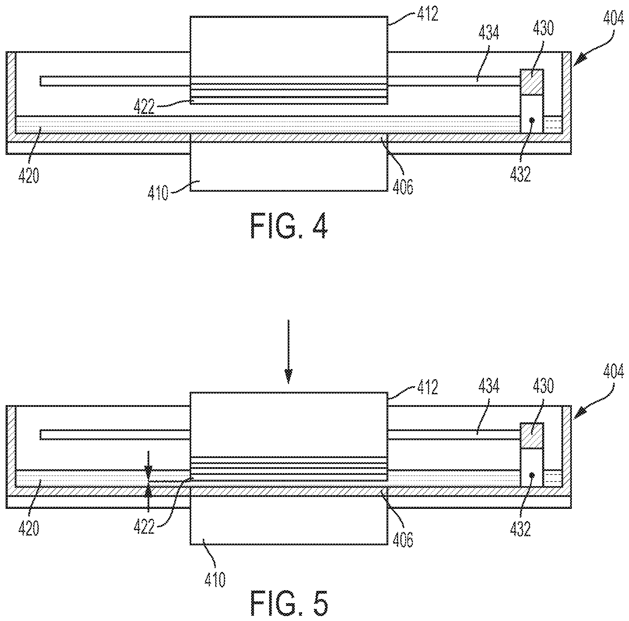

One suitable DLP process is disclosed in U.S. Patent No. 9,079,357 assigned to Ivoclar Vivadent AG and Technische Universität Wien, as well as WO 2010/045950 A1 and US 2011310370, each of which are hereby incorporated by reference and discussed below with reference to FIGS. 4-7. The apparatus includes a tank 404 having at least one translucent bottom portion 406 covering at least a portion of the exposure unit 410. The exposure unit 410 comprises a light source and modulator with which the intensity can be adjusted position-selectively under the control of a control unit, in order to produce an exposure field on the tank bottom 406 with the geometry desired for the layer currently to be formed. As an alternative, a laser may be used in the exposure unit, the light beam of which successively scans the exposure field with the desired intensity pattern by means of a mobile mirror, which is controlled by a control unit.

Opposite the exposure unit 410, a production platform 412 is provided above the tank 404; it is supported by a lifting mechanism (not shown) so that it is held in a height-adjustable way over the tank bottom 406 in the region above the exposure unit 410. The production platform 412 may likewise be transparent or translucent in order that light can be shone in by a further exposure unit above the production platform in such a way that, at least when forming the first layer on the lower side of the production platform 412, it can also be exposed from above so that the layer cured first on the production platform adheres thereto with even greater reliability.

The tank 404 contains a filling of highly viscous photopolymerizable material 420. The material level of the filling is much higher than the thickness of the layers which are intended to be defined for position-selective exposure. In order to define a layer of photopolymerizable material, the following procedure is adopted. The production platform 412 is lowered by the lifting mechanism in a controlled way so that (before the first exposure step) its lower side is immersed in the filling of photopolymerizable material 420 and approaches the tank bottom 406 to such an extent that precisely the desired layer thickness Δ (see FIG. 5) remains between the lower side of the production platform 412 and the tank bottom 406. During this immersion process, photopolymerizable material is displaced from the gap between the lower side of the production platform 412 and the tank bottom 406. After the layer thickness Δ has been set, the desired position-selective layer exposure is carried out for this layer, in order to cure it in the desired shape. Particularly when forming the first layer, exposure from above may also take place through the transparent or translucent production platform 412, so that reliable and complete curing takes place particularly in the contact region between the lower side of the production platform 412 and the photopolymerizable material, and therefore good adhesion of the first layer to the production platform 412 is ensured. After the layer has been formed, the production platform is raised again by means of the lifting mechanism.

These steps are subsequently repeated several times, the distance from the lower side of the layer 422 formed last to the tank bottom 406 respectively being set to the desired layer thickness Δ and the next layer thereupon being cured position-selectively in the desired way.

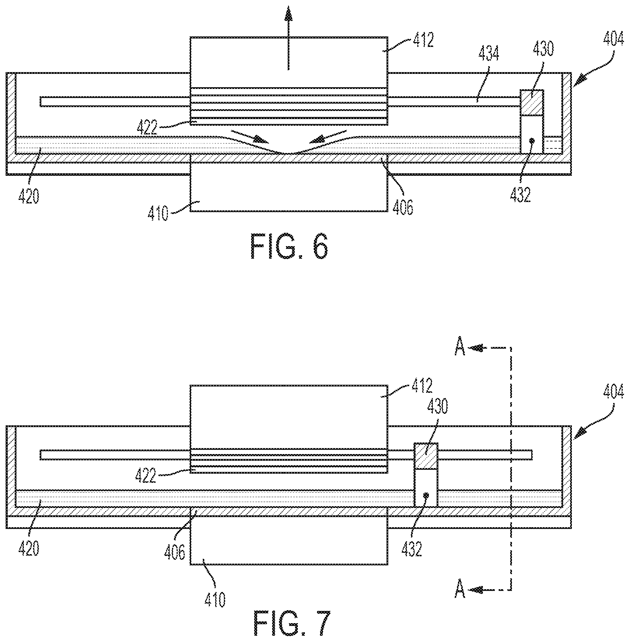

After the production platform 412 has been raised following an exposure step, there is a material deficit in the exposed region as indicated in FIG. 6. This is because after curing the layer set with the thickness Δ, the material of this layer is cured and raised with the production platform and the part of the shaped body already formed thereon. The photopolymerizable material therefore missing between the lower side of the already formed shaped body part and the tank bottom 406 must be filled from the filling of photopolymerizable material 420 from the region surrounding the exposed region. Owing to the high viscosity of the material, however, it does not flow by itself back into the exposed region between the lower side of the shaped body part and the tank bottom, so that material depressions or "holes" can remain here.

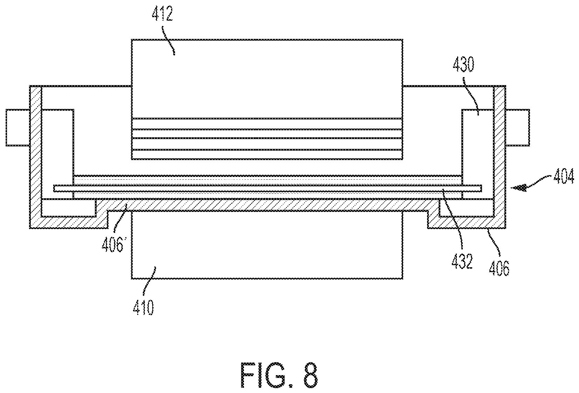

In order to replenish the exposure region with photopolymerizable material, an elongate mixing element 432 is moved through the filling of photopolymerizable material 420 in the tank. In the exemplary embodiment represented in FIGS. 4 to 8, the mixing element 432 comprises an elongate wire which is tensioned between two support arms 430 mounted movably on the side walls of the tank 404. The support arms 430 may be mounted movably in guide slots 434 in the side walls of the tank 404, so that the wire 432 tensioned between the support arms 430 can be moved relative to the tank 404, parallel to the tank bottom 406, by moving the support arms 430 in the guide slots 434. The elongate mixing element 432 has dimensions, and its movement is guided relative to the tank bottom, such that the upper edge of the elongate mixing element 432 remains below the material level of the filling of photopolymerizable material 420 in the tank outside the exposed region. As can be seen in the sectional view of FIG. 8, the mixing element 432 is below the material level in the tank over the entire length of the wire, and only the support arms 430 protrude beyond the material level in the tank. The effect of arranging the elongate mixing element below the material level in the tank 404 is not that the elongate mixing element 432 substantially moves material in front of it during its movement relative to the tank through the exposed region, but rather this material flows over the mixing element 432 while executing a slight upward movement. The movement of the mixing element 432 from the position shown in FIG. 6, to, for example, a new position in the direction indicated by the arrow A, is shown in FIG. 7. It has been found that by this type of action on the photopolymerizable material in the tank, the material is effectively stimulated to flow back into the material-depleted exposed region between the production platform 412 and the exposure unit 410.

The movement of the elongate mixing element 432 relative to the tank may firstly, with a stationary tank 404, be carried out by a linear drive which moves the support arms 430 along the guide slots 434 in order to achieve the desired movement of the elongate mixing element 432 through the exposed region between the production platform 412 and the exposure unit 410. As shown in FIG. 8, the tank bottom 406 has recesses 406' on both sides. The support arms 430 project with their lower ends into these recesses 406'. This makes it possible for the elongate mixing element 432 to be held at the height of the tank bottom 406, without interfering with the movement of the lower ends of the support arms 430 through the tank bottom 406.

Other alternative methods of DLP may be used to prepare the integrated core-shell molds of the present invention. For example, the tank may be positioned on a rotatable platform. When the workpiece is withdrawn from the viscous polymer between successive build steps, the tank may be rotated relative to the platform and light source to provide a fresh layer of viscous polymer in which to dip the build platform for building the successive layers.

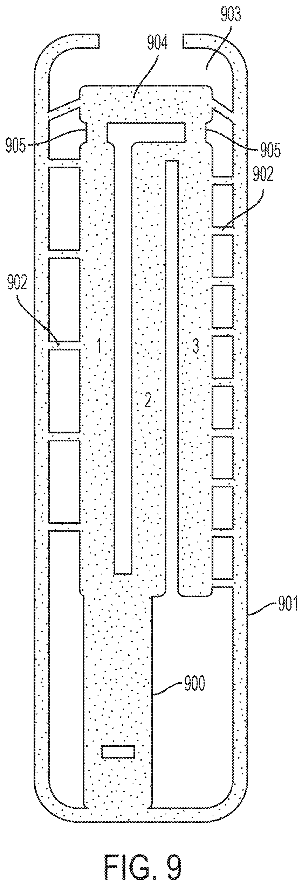

FIG. 9 shows a schematic side view of an integrated core-shell mold with filaments 902 connecting the core 900 and shell portions 901. By printing the ceramic mold using the above DLP printing process, the mold can be made in a way that allows the point of connections between the core and shell to be provided through filaments 902. At the tip portion of the integrated core-shell mold, there exists a void or space 903 between the shell 901 and the tip plenum core 904.Once the core-shell mold is printed, it may be subject to a post-heat treatment step to cure the printed ceramic polymer material. The cured ceramic mold may then be used similar to the traditional casting process used in the production of superalloy turbine blades. Notably because the filaments 902 are provided in a large quantity consistent with formation of a pattern of effusion cooling holes in the surface of a turbine blade, the need for a ball chute structure as shown in FIG. 2 may be eliminated. In this embodiment, the tip pins 905 connecting the tip plenum core 904 to the core 900 are retained. After removal of the ceramic mold, tip holes exist between the core 900 and tip plenum core 904 that may be subsequently brazed shut. However, the tip pins 905 may be eliminated, avoiding the need to braze shut tip holes connecting the core cavity with the tip plenum.

The filaments 902 are preferably cylindrical or oval shape but may be curved or non-linear. Their exact dimensions may be varied according to a desired film cooling scheme for a particular cast metal part. For example cooling holes may have a cross sectional area ranging from 0.01 to 2 mm². In a turbine blade, the cross sectional area may range from 0.01 to 0.15 mm², more preferably from 0.05 to 0.1 mm², and most preferably about 0.07 mm². In the case of a vane, the cooling holes may have a cross sectional area ranging from 0.05 to 0.2 mm², more preferably 0.1 to 0.18 mm², and most preferably about 0.16 mm². The spacing of the cooling holes is typically a multiple of the diameter of the cooling holes ranging from 2× to 10× the diameter of the cooling holes, most preferably about 4-7× the diameter of the holes.

The length of the filament 902 is dictated by the thickness of the cast component, e.g., turbine blade or stator vane wall thickness, and the angle at which the cooling hole is disposed relative to the surface of the cast component. The typical lengths range from 0.5 to 5 mm, more preferably between 0.7 to 1 mm, and most preferably about 0.9 mm. The angle at which a cooling hole is disposed is approximately 5 to 35° relative to the surface, more preferably be-tween 10 to 20°, and most preferably approximately 12°. It should be appreciated that the methods of casting according to the present invention allow for formation of cooling holes having a lower angle relative to the surface of the cast component than currently available using conventional machining techniques.

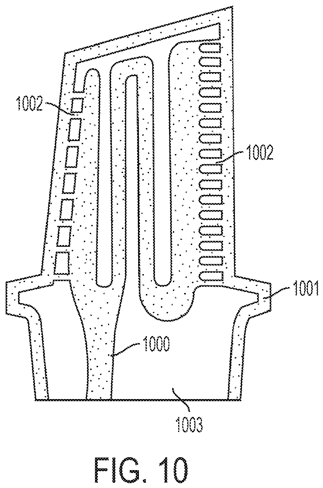

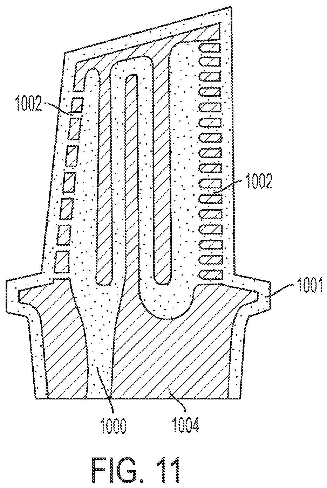

FIG. 10 shows a side view of an integrated core-shell mold not according to an embodiment of the present invention. As with the schematic shown in FIG. 9, the core 1000 is connected to the shell 1001 through several filaments 1002. The core-shell mold 1000/1001 defines a cavity 1003 for investment casting a turbine blade. FIG. 11 shows the cavity 1003 filled with a metal 1004, such as a nickel based alloy, i.e., Inconel. Upon leaching of the ceramic core-shell, the resulting cast object is a turbine blade having a cooling hole pattern in the surface of the blade. It should be appreciated that although FIGS. 10-11 provide a cross sectional view showing cooling holes at the leading and trailing edge of the turbine blade, that additional cooling holes may be provided where desired including on the sides of the turbine blades or any other location desired. In particular, the present invention may be used to form cooling holes within the casting process in any particular design. In other words, one would be able to produce conventional cooling holes in any pattern where drilling was used previously to form the cooling holes. However, the present invention will allow for cooling hole patterns previously unattainable due to the limitations of conventional technologies for creating cooling holes within cast components, i.e., drilling.

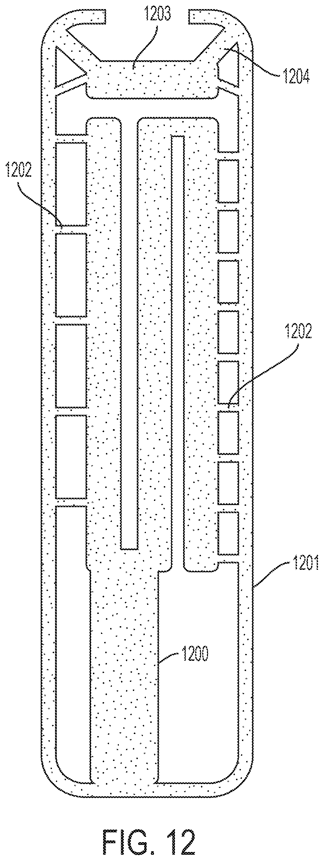

FIG. 12 is a schematic view of an integrated core-shell mold having a floating tip plenum core 1203. The tip plenum core 1203 is held in place relative to the shell with core print filaments 1204, eliminating the need for tip pins as shown in FIG. 9 or a shell lock to attach the tip plenum core to the shell as used in conventional investment casting. In this embodiment, the core print filaments 1204 exit at or near the top of the tip plenum core 1203. The core print filaments 1204 provide additional support holding tip plenum core 1203 in place, and have a cross sectional area that is sufficiently large to support the weight of the tip plenum core during the casting process. For example the cross sectional area of a core print filament is generally larger than the cross sectional area of the cooling hole filaments. In one case, the cross sectional area of the core print filament is greater than 2 mm², and may have an area on the order of a square centimeter.

The core print filaments 1204 may be necessary if there are no cooling hole filaments between the tip plenum core and the shell, or if the amount or size of the filaments are insufficient to hold the tip plenum core in place during the metal casting step. The provision of core print filaments 1204 allow the tip plenum core 1203 to float above and be disconnected from the main core. This eliminates the need for tip pins that result in tip holes connecting the surface of the turbine blade exposed through the tip plenum to the main core cavity of the turbine blade. The elimination of the tip holes is advantageous since it eliminates the post-casting step of brazing tip holes shut. This design provides a novel core-shell structure and eliminates conventional structures such as tip pins and/or a shell lock to hole the tip core relative to the shell.

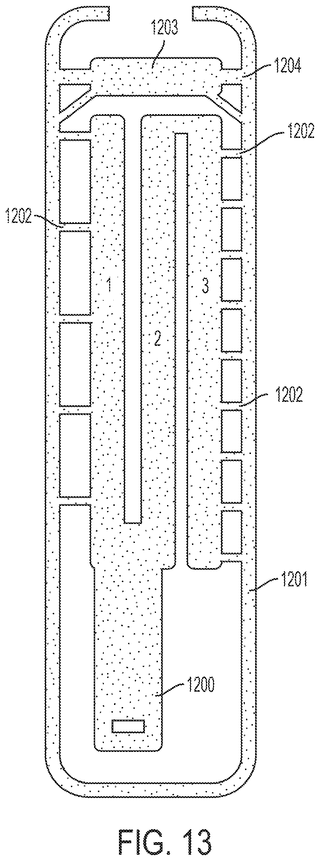

After leaching, the resulting holes in the turbine blade from the core print filaments may be brazed shut if desired. Otherwise the holes left by the core print filaments may be incorporated into the design of the internal cooling passages. Alternatively, cooling hole filaments may be provided to connect the tip plenum core to the shell in a sufficient quantity to hold the tip plenum core in place during the metal casting step. FIG. 13 provides an alternative design where core filaments exit to the side of the blade tip plenum 1203.

After printing the core-shell mold structures in accordance with the invention, the core-shell mold may be cured and/or fired depending upon the requirements of the ceramic core photopolymer material. Molten metal may be poured into the mold to form a cast object in the shape and having the features provided by the integrated core-shell mold. In the case of a turbine blade, the molten metal is preferably a superalloy metal that formed into a single crystal superalloy turbine blade using techniques known to be used with conventional investment casting molds.

This written description uses examples to disclose the invention, including the preferred embodiments, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A method for fabricating a ceramic core shell casting mold of a turbine blade or a stator vane, comprising:
(a) contacting a cured portion of a workpiece with a liquid ceramic photopolymer;
(b) irradiating a portion of the liquid ceramic photopolymer adjacent to the cured portion through a window contacting the liquid ceramic photopolymer;
(c) removing the workpiece from the uncured liquid ceramic photopolymer; and
(d) repeating steps (a) - (c) until a ceramic core shell casting mold is formed, the ceramic core shell casting mold comprising a main core portion, a tip plenum core (1203) floating above and disconnected from the main core portion, and a shell portion (1201) with at least one cavity between the main core portion and the shell portion (1201), the cavity adapted to define the shape of a cast component upon casting and removal of the ceramic core shell casting mold, and
at least one core print filament (1204) for holding the tip plenum core (1203) in place, the at least one core print filament (1204) connecting the tip plenum core (1203) and the shell portion (1201).

2. The method of claim 1, wherein the process comprises, after step (d), a step (e) comprising pouring a liquid metal into the ceramic core shell casting mold and solidifying the liquid metal to form the cast component.

3. The method of claim 2, wherein the process comprises, after step (e), a step (f) comprising removing the ceramic core shell casting mold from the cast component.

4. The method of any one of claims 1-3, wherein the at least one core print filaments (1204) has a cross sectional area of at least 2 mm².

5. The method of any one of claims 1-4, wherein the process comprises leaching, and the at least one core print filament (1204) provides a cooling passage in the turbine blade or stator vane after leaching.

6. The method of any one of claims 1-5, wherein the ceramic core shell casting mold comprises a plurality of cooling hole filaments (1202) joining the main core portion and the shell portion (1201) where each of the plurality of cooling hole filament (1202) spans between the main core portion and the shell portion (1201), the cooling hole filaments (1202) adapted to define a plurality of cooling holes in the turbine blade or the stator vane upon removal of the ceramic core shell casting mold.

7. The method of claim 6, wherein the plurality of cooling hole filaments (1202) have a cross sectional area ranging from 0.01 to 2 mm².

8. A method of preparing a cast component, namely a turbine blade or a stator vane, comprising:
pouring a liquid metal into a ceramic core shell casting mold and solidifying the liquid metal to form the cast component, the ceramic core shell casting mold comprising a main core portion, a tip plenum core (1203) floating above and disconnected from the main core portion, and a shell portion (1201) with at least one cavity between the core portion and the shell portion (1201), the cavity adapted to define the shape of a cast component upon casting and removal of the ceramic core shell casting mold, and at least one core print filament (1204) for holding the tip plenum core (1203) in place, the at least one core print filament (1204) connecting the tip plenum core (1203) and the shell portion (1201); and
removing the ceramic core shell casting mold from the cast component.

9. The method of claim 8, wherein the ceramic core shell casting mold comprises a plurality of cooling hole filaments (1202) joining the main core portion and the shell portion (1201) where each of the plurality of cooling hole filament spans (1202) between the main core portion and the shell portion (1201), the plurality of cooling hole filaments (1292) adapted to define a plurality of cooling holes in the turbine blade or the stator vane upon removal of the ceramic core shell casting mold.

10. The method of claim 9, wherein the plurality of cooling hole filaments (1202) have a cross sectional area ranging from 0.01 to 2 mm².

11. A ceramic core shell casting mold of a turbine blade or a stator vane, comprising:
a main core portion, a tip plenum core (1203) floating above and disconnected from the main core portion, and a shell portion (1201) with at least one cavity between the main core portion and the shell portion (1201), wherein the main core portion, the tip plenum core (1203) and shell portion (1201) being formed of a photopolymerized material,
the cavity adapted to define the shape of a cast component upon casting and removal of the ceramic core shell casting mold, and at least one core print filament (1204) for holding the tip plenum core (1203) in place, the at least one core print filament (1204) being formed of the photopolymerized material and connecting the tip plenum core (1203) and the shell portion (1201) to form the ceramic core shell casting mold.

12. The ceramic core shell casting mold of claim 11, wherein the ceramic core shell casting mold comprises a plurality of cooling hole filaments (1202) joining the main core portion and the shell portion where each filament spans between the main core portion and the shell portion (1201), the plurality of cooling hole filaments (1202) adapted to define a plurality of cooling holes in the turbine blade or the stator vane upon removal of the ceramic core shell casting mold.

13. The ceramic core shell casting mold of claim 12, wherein the plurality of cooling hole filaments (1202) have a cross sectional area ranging from 0.01 to 2 mm².

14. The ceramic core shell casting mold of any one of claims 11-13, wherein the photopolymerized material is a photopolymerized ceramic.

15. The ceramic casting mold of any one of claims 11-13, wherein the photopolymerized material is a cured photopolymerized ceramic.

## Patentansprüche

1. Verfahren zum Fertigen einer keramischen Kern-Schale-Gießform einer Turbinenschaufel oder Statorleitschaufel, umfassend:
(a) Kontaktieren eines gehärteten Teils eines Werkstücks mit einem flüssigen keramischen Photopolymer;
(b) Bestrahlen eines Teils des flüssigen keramischen Photopolymers, der an den gehärteten Teil angrenzt, durch ein Fenster, welches das flüssige keramische Photopolymer kontaktiert;
(c) Entfernen des Werkstücks von dem ungehärteten, flüssigen keramischen Photopolymer; und
(d) Wiederholen der Schritte (a) - (c), bis eine keramische Kern-Schale-Gießform gebildet ist, wobei die keramische Kern-Schale-Gießform einen Hauptkernteil, einen Spitzenkammerkern (1203), der über dem und von dem Hauptkernteil getrennt schwebt, und einen Schalenteil (1201) mit zumindest einem Hohlraum zwischen dem Hauptkernteil und dem Schalenteil (1201) aufweist, wobei der Hohlraum eingerichtet ist, nach dem Gießen und Entfernen der keramischen Kern-Schale-Gießform die Gestalt einer Gießkomponente zu definieren, und
zumindest ein Kerndruckfilament (1204) zum Halten des Spitzenkammerkerns (1203), wobei das zumindest eine Kerndruckfilament (1204) den Spitzenkammerkern (1203) und den Schalenteil (1201) verbindet.

2. Verfahren nach Anspruch 1, wobei das Verfahren nach Schritt (d) einen Schritt (e) umfasst, welcher das Gießen eines flüssigen Metalls in die keramische Kern-Schale-Gießform und das Verfestigen des flüssigen Metalls zum Bilden der Gießkomponente umfasst.

3. Verfahren nach Anspruch 2, wobei das Verfahren nach Schritt (e) einen Schritt (f) umfasst, welcher das Entfernen der keramischen Kern-Schale-Gießform von der Gießkomponente umfasst.

4. Verfahren nach einem der Ansprüche 1-3, wobei das zumindest eine Kerndruckfilament (1204) eine Querschnittsfläche von zumindest 2 mm² hat.

5. Verfahren nach einem der Ansprüche 1-4, wobei der Prozess Auslaugen umfasst und das zumindest eine Kerndruckfilament (1204) nach dem Auslaugen in der Turbinenschaufel oder Statorleitschaufel einen Kühlkanal bereitstellt.

6. Verfahren nach einem der Ansprüche 1-5, wobei die keramische Kern-Schale-Gießform eine Vielzahl von Kühllochfilamenten (1202) aufweist, welche den Hauptkernteil und den Schalenteil (1201) dort verbinden, wo jedes der Vielzahl von Kühllochfilamenten (1202) sich zwischen dem Hauptkernteil und dem Schalenteil (1201) erstreckt, wobei die Kühllochfilamente (1202) eingerichtet sind, nach dem Entfernen der keramischen Kern-Schale-Gießform eine Vielzahl von Kühllöchern in der Turbinenschaufel oder Statorleitschaufel zu definieren.

7. Verfahren nach Anspruch 6, wobei die Vielzahl von Kühllochfilamenten (1202) eine Querschnittsfläche von 0,01 bis 2 mm² haben.

8. Verfahren zum Herstellen einer Gießkomponente, nämlich einer Turbinenschaufel oder Statorleitschaufel, umfassend:
Gießen eines flüssigen Metalls in eine keramische Kern-Schale-Gießform und
Verfestigen des flüssigen Metalls zum Bilden der Gießkomponente, wobei die keramische Kern-Schale-Gießform einen Hauptkernteil, einen Spitzenkammerkern (1203), der über dem und von dem Hauptkernteil getrennt schwebt, und einen Schalenteil (1201) mit zumindest einem Hohlraum zwischen dem Hauptkernteil und
dem Schalenteil (1201) aufweist, wobei der Hohlraum eingerichtet ist, nach dem Gießen und Entfernen der keramischen Kern-Schale-Gießform die Gestalt einer Gießkomponente zu definieren, und zumindest ein Kerndruckfilament (1204) zum Festhalten des Spitzenkammerkerns (1203), wobei das zumindest eine Kerndruckfilament (1204) den Spitzenkammerkern (1203) und den Schalenteil (1201) verbindet; und
Entfernen der keramischen Kern-Schale-Gießform von der Gießkomponente.

9. Verfahren nach Anspruch 8, wobei die keramische Kern-Schale-Gießform eine Vielzahl von Kühllochfilamenten (1202) aufweist, welche den Hauptkernteil und den Schalenteil (1201) dort verbinden, wo jedes der Vielzahl von Kühllochfilamenten (1202) sich zwischen dem Hauptkernteil und dem Schalenteil (1201) erstreckt, wobei die Vielzahl von Kühllochfilamenten (1292) eingerichtet sind, nach dem Entfernen der keramischen Kern-Schale-Gießform eine Vielzahl von Kühllöchern in der Turbinenschaufel oder Statorleitschaufel zu definieren.

10. Verfahren nach Anspruch 9, wobei die Vielzahl von Kühllochfilamenten (1202) eine Querschnittsfläche von 0,01 bis 2 mm² haben.

11. Keramische Kern-Schale-Gießform einer Turbinenschaufel oder Statorleitschaufel, aufweisend:
einen Hauptkernteil, einen Spitzenkammerkern (1203), der über dem und von dem Hauptkernteil getrennt schwebt, und einen Schalenteil (1201) mit zumindest einem Hohlraum zwischen dem Hauptkernteil und dem Schalenteil (1201), wobei der Hauptkernteil, der Spitzenkammerkern (1203) und der Schalenteil (1201) aus einem photopolymerisierten Material gebildet sind,
wobei der Hohlraum eingerichtet ist, nach dem Gießen und Entfernen der keramischen Kern-Schale-Gießform die Gestalt einer Gießkomponente zu definieren, und zumindest ein Kerndruckfilament (1204) zum Festhalten des Spitzenkammerkerns (1203), wobei das zumindest eine Kerndruckfilament (1204) aus dem photopolymerisierten Material gebildet ist und den Spitzenkammerkern (1203) und den Schalenteil (1201) verbindet, um die keramische Kern-Schale-Gießform zu bilden.

12. Keramische Kern-Schale-Gießform nach Anspruch 11, wobei die keramische Kern-Schale-Gießform eine Vielzahl von Kühllochfilamenten (1202) aufweist, welche den Hauptkernteil und den Schalenteil dort verbinden, wo jedes Filament sich zwischen dem Hauptkernteil und dem Schalenteil (1201) erstreckt, wobei die Vielzahl von Kühllochfilamenten (1202) eingerichtet sind, nach dem Entfernen der keramischen Kern-Schale-Gießform eine Vielzahl von Kühllöchern in der Turbinenschaufel oder der Statorleitschaufel zu definieren.

13. Keramische Kern-Schale-Gießform nach Anspruch 12, wobei die Vielzahl von Kühllochfilamenten (1202) eine Querschnittsfläche von 0,01 bis 2 mm² haben.

14. Keramische Kern-Schale-Gießform nach einem der Ansprüche 11-13, wobei das photopolymerisierte Material eine photopolymerisierte Keramik ist.

15. Keramische Gießform nach einem der Ansprüche 11-13, wobei das photopolymerisierte Material eine gehärtete photopolymerisierte Keramik ist.

## Revendications

1. Procédé de fabrication d'un moule de coulée à noyau-enveloppe en céramique d'une aube de turbine ou d'une aube de stator, comprenant :
(a) la mise en contact d'une partie durcie d'une pièce avec un photopolymère en céramique liquide ;
(b) l'irradiation d'une partie du photopolymère en céramique liquide adjacente à la partie durcie par le biais d'une fenêtre qui entre en contact avec le photopolymère en céramique liquide ;
(c) le retrait de la pièce du photopolymère en céramique liquide non durci ; et
(d) la répétition des étapes (a)-(c) jusqu'à ce qu'un moule de coulée à noyau-enveloppe en céramique soit formé, le moule de coulée à noyau-enveloppe en céramique comprenant une partie noyau principal, un noyau de chambre de pointe (1203) flottant au-dessus et déconnecté de la partie noyau principal, et une partie enveloppe (1201) avec au moins une cavité entre la partie noyau principal et la partie enveloppe (1201), la cavité étant adaptée à définir la forme d'un composant de coulée lors de la coulée et du retrait du moule de coulée à noyau-enveloppe en céramique, et
au moins un filament d'impression de noyau (1204) destiné à maintenir le noyau de chambre de pointe (1203) en position, l'au moins un filament d'impression de noyau (1204) connectant le noyau de chambre de pointe (1203) et la partie enveloppe (1201).

2. Procédé selon la revendication 1, dans lequel le processus comprend, après l'étape (d), une étape (e) comprenant le versement d'un métal liquide dans le moule de coulée à noyau-enveloppe en céramique et la solidification du métal liquide pour former le composant de coulée.

3. Procédé selon la revendication 2, dans lequel le processus comprend, après l'étape (e), une étape (f) comprenant le retrait du moule de coulée à noyau-enveloppe en céramique du composant de coulée.

4. Procédé selon l'une quelconque des revendications 1-3, dans lequel l'au moins un filament d'impression de noyau (1204) présente une zone de coupe transversale d'au moins 2 mm².

5. Procédé selon l'une quelconque des revendications 1-4, dans lequel le processus comprend la lixiviation, et l'au moins un filament d'impression de noyau (1204) fournit un passage de refroidissement dans l'aube de turbine ou l'aube de stator après la lixiviation.

6. Procédé selon l'une quelconque des revendications 1-5, dans lequel le moule de coulée à noyau-enveloppe en céramique comprend une pluralité de filaments de trou de refroidissement (1202) assemblant la partie noyau principal et la partie enveloppe (1201) où chacun de la pluralité de filaments de trou de refroidissement (1202) s'étend entre la partie noyau principal et la partie enveloppe (1201), les filaments de trou de refroidissement (1202) étant adaptés à définir une pluralité de trous de refroidissement dans l'aube de turbine ou l'aube de stator lors du retrait du moule de coulée à noyau-enveloppe en céramique.

7. Procédé selon la revendication 6, dans lequel la pluralité de filaments de trou de refroidissement (1202) présente une zone de coupe transversale allant de 0,01 à 2 mm².

8. Procédé de préparation d'un composant de coulée, à savoir une aube de turbine ou une aube de stator, comprenant :
le versement d'un métal liquide dans un moule de coulée à noyau-enveloppe en céramique et la solidification du métal liquide pour former le composant de coulée, le moule de coulée à noyau-enveloppe en céramique comprenant une partie noyau principal, un noyau de chambre de pointe (1203) flottant au-dessus et déconnecté de la partie noyau principal, et une partie enveloppe (1201) avec au moins une cavité entre la partie noyau et la partie enveloppe (1201), la cavité étant adaptée à définir la forme d'un composant de coulée lors de la coulée et du retrait du moule de coulée à noyau-enveloppe en céramique, et au moins un filament d'impression de noyau (1204) destiné à maintenir le noyau de chambre de pointe (1203) en position, l'au moins un filament d'impression de noyau (1204) connectant le noyau de chambre de pointe (1203) et la partie enveloppe (1201) ; et
le retrait du moule de coulée à noyau-enveloppe en céramique du composant de coulée.

9. Procédé selon la revendication 8, dans lequel le moule de coulée à noyau-enveloppe en céramique comprend une pluralité de filaments de trou de refroidissement (1202) assemblant la partie noyau principal et la partie enveloppe (1201) où chacun de la pluralité de filaments de trou de refroidissement (1202) s'étend entre la partie noyau principal et la partie enveloppe (1201), la pluralité de filaments de trou de refroidissement (1292) étant adaptée à définir une pluralité de trous de refroidissement dans l'aube de turbine ou l'aube de stator lors du retrait du moule de coulée à noyau-enveloppe en céramique.

10. Procédé selon la revendication 9, dans lequel la pluralité de filaments de trou de refroidissement (1202) présente une zone de coupe transversale allant de 0,01 à 2 mm².

11. Moule de coulée à noyau-enveloppe en céramique d'une aube de turbine ou d'une aube de stator, comprenant :
une partie noyau principal, un noyau de chambre de pointe (1203) flottant au-dessus et déconnecté de la partie noyau principal, et une partie enveloppe (1201) avec au moins une cavité entre la partie noyau principal et la partie enveloppe (1201), dans lequel la partie noyau principal, le noyau de chambre de pointe (1203) et la partie enveloppe (1201) sont formés d'un matériau photopolymérisé,
la cavité étant adaptée à définir la forme d'un composant de coulée lors de la coulée et du retrait du moule de coulée à noyau-enveloppe en céramique, et au moins un filament d'impression de noyau (1204) destiné à maintenir le noyau de chambre de pointe (1203) en position, l'au moins un filament d'impression de noyau (1204) étant formé du matériau photopolymérisé et connectant le noyau de chambre de pointe (1203) et la partie enveloppe (1201) pour former le moule de coulée à noyau-enveloppe en céramique.

12. Moule de coulée à noyau-enveloppe en céramique selon la revendication 11, dans lequel le moule de coulée à noyau-enveloppe en céramique comprend une pluralité de filaments de trou de refroidissement (1202) assemblant la partie noyau principal et la partie enveloppe où chaque filament s'étend entre la partie noyau principal et la partie enveloppe (1201), la pluralité de filaments de trou de refroidissement (1202) étant adaptée à définir une pluralité de trous de refroidissement dans l'aube de turbine ou l'aube de stator lors du retrait du moule de coulée à noyau-enveloppe en céramique.

13. Moule de coulée à noyau-enveloppe en céramique selon la revendication 12, dans lequel la pluralité de filaments de trou de refroidissement (1202) présente une zone de coupe transversale allant de 0,01 à 2 mm².

14. Moule de coulée à noyau-enveloppe en céramique selon l'une quelconque des revendications 11-13, dans lequel le matériau photopolymérisé est une céramique photopolymérisée.

15. Moule de coulée en céramique selon l'une quelconque des revendications 11-13, dans lequel le matériau photopolymérisé est une céramique photopolymérisée durcie.
